(19) 

Europäisches Patentamt
European Patent Office
Office européen des brevets

(11) **EP 4 203 014 B1**

(12) **EUROPEAN PATENT SPECIFICATION**

(45) Date of publication and mention
of the grant of the patent:
**25.02.2026 Bulletin 2026/09**

(21) Application number: **21888447.6**

(22) Date of filing: **26.10.2021**

(51) International Patent Classification (IPC):
*H01L 23/367* (2006.01)      *H01L 23/473* (2006.01)
*H01L 23/373* (2006.01)

(52) Cooperative Patent Classification (CPC):
**H10W 40/228; H10W 40/255; H10W 40/47**

(86) International application number:
**PCT/CN2021/126306**

(87) International publication number:
**WO 2022/095750 (12.05.2022 Gazette 2022/19)**

(54) **HEAT DISSIPATION STRUCTURE OF COOLING PLATE FOR POWER SEMICONDUCTOR MODULE**

WÄRMEABLEITUNGSSTRUKTUR EINER KÜHLPLATTE FÜR EIN LEISTUNGSHALBLEITERMODUL

STRUCTURE DE DISSIPATION DE CHALEUR DE PLAQUE DE REFROIDISSEMENT POUR MODULE SEMI-CONDUCTEUR DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.11.2020  CN 202011230363**

(43) Date of publication of application:
**28.06.2023  Bulletin 2023/26**

(73) Proprietor: **Zhenghai Group Co., Ltd.**
**Shandong 264006 (CN)**

(72) Inventors:
• **WANG, Changcheng**
**Yantai, Shandong 264006 (CN)**
• **TANG, Yusheng**
**Yantai, Shandong 264006 (CN)**
• **MAO, Xianye**
**Yantai, Shandong 264006 (CN)**
• **GUO, Jianwen**
**Yantai, Shandong 264006 (CN)**

(74) Representative: **Prinz & Partner mbB**
**Patent- und Rechtsanwälte**
**Rundfunkplatz 2**
**80335 München (DE)**

(56) References cited:
**EP-A1- 1 926 143      EP-A1- 3 460 838
CN-A- 1 725 479      CN-A- 103 697 749
CN-A- 104 807 362      CN-A- 105 188 307
CN-A- 110 220 402      CN-A- 112 466 825
CN-U- 207 967 049      JP-A- 2016 004 828
US-A1- 2009 145 581      US-B2- 10 015 907**

**Description**

This application claims priority to Chinese Patent Application No. 202011230363.6, titled "HEAT DISSIPATION STRUCTURE OF COOLING PLATE FOR POWER SEMICONDUCTOR MODULE", filed on November 6, 2020 with the China National Intellectual Property Administration.

**FIELD**

The present disclosure relates to the technical field of cooling of power devices, and in particular to a heat dissipation structure of a cooling plate for a power semiconductor module.

**BACKGROUND**

A power semiconductor module is an integrated module in which power electronic components are assembled based on certain functions. The power semiconductor module has advantages of small size and high-power density, and thus has a wide range of applications in the field of new energy vehicles. With the development of the new energy vehicles towards high power and long battery life, application environment of the power semiconductor module becomes increasingly severe, and reliability of the power semiconductor module has attracted widespread attention.

Thermal reliability is an important part of the reliability of the power semiconductor module and the power semiconductor module has to show good heat dissipation performance in terms of the thermal reliability. The heat in the power semiconductor module mainly comes from a chip, a copper layer and a busbar terminal. The heat generated by the chip and the copper layer is mainly transferred via a copper-clad ceramic substrate to a cooling plate, and finally is transferred out of the power semiconductor module by coolant. It can be seen that a heat dissipation structure of the cooling plate is particularly important for the heat dissipation of the power semiconductor module.

There are three basic ways of heat transfer, namely, heat conduction, heat convection and heat radiation. In a heat dissipation process of the power semiconductor module, the heat is dissipated mainly through the convective heat transfer between the cooling plate and the coolant.

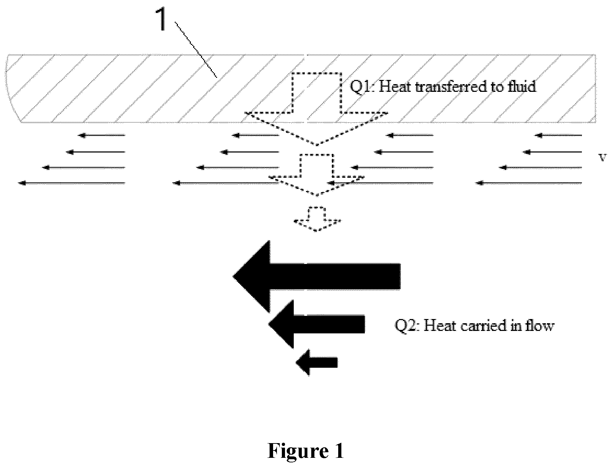

Convective heat transfer is a combination of heat transfer caused by the macroscopic flow of fluid and heat transfer caused by the thermal conduction of molecules in the fluid. To illustrate this phenomenon, steady-state heat transfer through a flat plate is taken as an example, as shown in Figure 1. Assuming that a temperature of the incoming coolant is lower than a temperature of the cooling plate 1, a flow velocity v in a thin fluid layer close to a wall of the cooling plate 1 gradually decreases, and finally the fluid on the wall is stagnant and fails to flow freely due to viscosity of the fluid. In this case, due to the heat conduction of molecules in the fluid, the amount of heat $Q_1$ is transferred from a surface of the plate to the fluid so that the fluid is heated. The heated fluid moves forward and carries away the amount of heat $Q_2$. Therefore, the amount of heat $Q_1$ to be transferred by the molecules in the fluid in a direction perpendicular to the surface of the plate gradually decreases, as indicated by a dashed arrow in Figure 1. Since the heat transferred from the wall of the cooling plate 1 to the fluid has been all carried away by the moving fluid at the outer boundary of the thin fluid layer, a rate of change in the temperature of the fluid in the direction perpendicular to the surface of the plate approximates zero, and thus the thermal conductivity of the molecules in the fluid in the direction perpendicular to the surface of the plate is also zero. A dotted arrow in Figure 1 represents the amount of heat $Q_1$ transferred by the heat conduction of the molecules in a direction perpendicular to the flow direction of the surface of the plate, and a width of the arrow represents magnitude of the heat flow. A thick solid arrow represents the amount of heat $Q_2$ carried away by the fluid, and a width of the arrow represents magnitude of the heat flow. v represents the main flow velocity of the fluid and a thin solid arrow indicates magnitude and a direction of *v*.

The Equation for convective heat transfer is as follows:

$$\Phi = hA\left(T_w - T_f\right) = hA\Delta T \qquad (1)$$

In the Equation, $\Phi$ represents the amount of heat carried away by the convective heat transfer between the cooling plate and the coolant, in the unit of *W*, $T_w$ and $T_f$ represent an average temperature of a solid wall and an average temperature of a liquid wall at an interface between fluid and solid, respectively, in the unit of *K*. *h* is a convective heat transfer coefficient in the unit of $W/(m^2 \cdot K)$. *A* represents a convective heat transfer area in the unit of $m^2$, and $\Delta T$ represents a temperature difference between $T_w$ and $T_f$, in the unit of *K*.

It can be seen from Equation (1) that the heat carried away by the convective heat transfer may be increased by increasing the convective heat transfer coefficient, the heat transfer area and the temperature difference. The convective heat transfer coefficient is related to multiple factors such as the velocity, density, dynamic viscosity and specific heat capacity of the coolant and the thermal conductivity coefficient of the cooling plate. The heat exchange area is related to the heat dissipation structure of the cooling plate. The temperature difference is related to process technology.

Researches on fluid mechanics have shown that there are two different flow regimes, i.e., laminar flow and turbulent flow, for viscous fluid. In laminar flow, the fluid micelles flow in regular layers along the flow direction, as shown by the thin solid arrow in Figure 1. In turbulent flow, in addition to the movement in the flow direction, the fluid micelles also pulsate irregularly. When the fluid micelles pulsate from one position to another, vigorous mixing occurs between the various parts of the fluid micelles, thus producing two effects: additional momentum exchange occurs between the fluids in the layers at different flow velocities, and additional heat exchange occurs between the fluids in the layers at different temperatures. According to the convective heat transfer theory, the convective heat transfer coefficient in laminar flow is smaller than that in turbulent flow given other conditions are the same, and it can be seen that the heat carried away by the turbulent flow is greater than that carried away by the laminar flow.

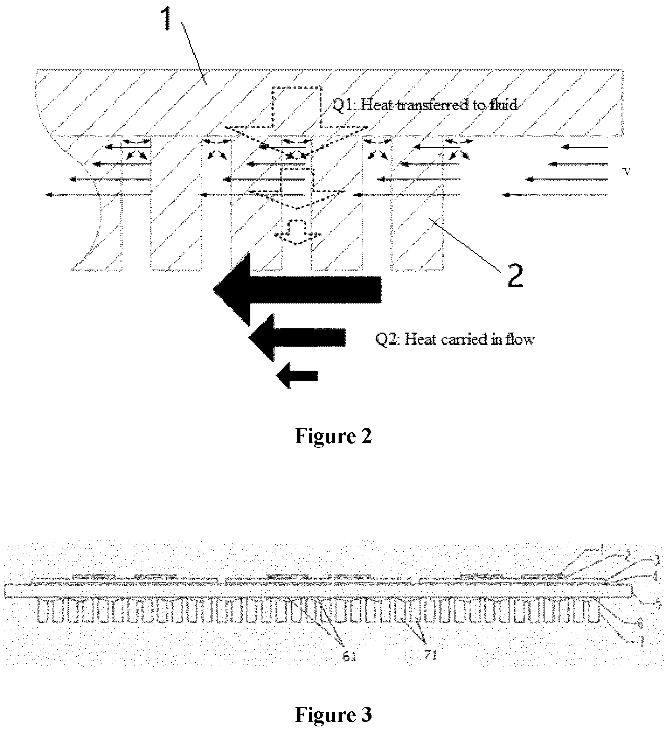

In most cases, the bottom of the cooling plate 1 of a common power semiconductor module is in a flat plate, as shown in Figure 1. Alternatively, the bottom is formed by a flat plate and pin ribs 2, and the pin ribs 2 are arranged at intervals on the bottom of the cooling plate 1 as shown in Figure 2. The viscous fluid at the interface between fluid and solid shown in Figure 1 is completely in laminar flow. Although the fluid at the interface fluid and solid shown in Figure 2 is partially in the turbulent flow, only few fluid micelles are in turbulent flow, and the majority fluid micelles are still in the laminar flow. With reference to Equation (1), it can be seen that the heat dissipation structure of the cooling plate shown in Figures 1 and 2 does not substantially change the type of fluid flow at the interface between fluid and solid, and thus the convective heat transfer coefficient $h$ does not substantially increase. Only the convective heat transfer area $A$ is increased and the heat dissipation capacity is not significantly enhanced in Figure 2 when compared with Figure 1.

With the increasing severe application environment of the power semiconductor module, common heat dissipation structure of the cooling plate fails to meet the requirements of heat dissipation, which seriously affects the thermal reliability of the power semiconductor module, resulting in a reduction in the overall performance and service life of the power semiconductor module.

It is disclosed in EP 3 460 838 A1 a power module substrate including a ceramic substrate and a circuit layer having a circuit pattern. In an interface between the circuit layer and the ceramic substrate, a Cu-Sn layer and a Ti-containing layer are laminated in this order from the ceramic substrate side. In a cross-sectional shape of an end portion of the circuit pattern of the circuit layer, an angle, formed between a surface of the ceramic substrate and an end face of the Cu-Sn layer is set in a range equal to or greater than 80° and equal to or smaller than 100°, and a maximum protrusion length L of the Cu-Sn layer or the Ti-containing layer from an end face of the circuit layer is set in a range equal to or greater than 2 $\mu$m and equal to or smaller than 15 $\mu$m.

It is disclosed in US 10 015 907 B2 a heat dissipating device including a thermal conductive substance, a plurality of heat-radiating protrusions and a plurality of turbulence-generating structures. The thermal conductive substance has a first surface and a second surface opposite to the first surface. The heat-radiating protrusions are integrally formed with the thermal conductive substance on the first surface. At least one of the turbulence-generating structures is formed on the first surface of the thermal conductive substance in concaved manner, and arranged around a bottom periphery of the heat-radiating protrusions, so as to obstruct a development of a boundary layer around the bottom of the heat-radiating protrusions.

It is disclosed in JP 2016 004828 A a liquid cooling type cooling device including a casing, having a top wall and a bottom wall, inside which a cooling liquid flow path is formed; and a radiator disposed in the cooling liquid flow path in the casing. A heating element mounting portion is provided on the outer surface of the top wall of the casing. The radiator comprises: a linear base portion having a constant length; and a plurality of heat radiating members which are integrally formed with the base portion at intervals in the longitudinal direction of the base portion and which are formed of a plurality of pin fins projecting upward with respect to the base portion. The heat radiating member is formed of a press-molded product. The radiator is formed by arranging all heat radiating members at intervals and mutually connecting them by connection members. The base portion is brazed to the bottom wall of the casing and the tip of the pin fin is brazed to the top wall of the casing.

It is disclosed in US 2009/0145581 A1 a non-linear fin heat sink provided for dissipating/removing heat uniformly from a device, where the heat generation is non-uniform over that device, while also providing a small and relatively lightweight heat sink. The heat sink has extended surface protrusions that are optimally shaped in recognition of convective heat transfer, conductive heat transfer, and flow resistance allowing the heat sink to offset the temperature rise of a coolant media and provide enhanced cooling for the coolant temperature, deliver optimized cooling efficiency per the local physical properties of the coolant media, be used with a fluid for effectuating heat transfer; either liquid coolant, gas coolant or a combination thereof. Furthermore the heat sink features turbulence enhancement of the coolant stream by a pin array through which coolant stream passes, such fin array featuring a non-linear shape, spacing, and height pattern to provide optimal cooling while simultaneously reducing volume and flow resistance.

## SUMMARY

The technical problem to be solved by the present disclosure is to provide a heat dissipation structure of a cooling plate for a power semiconductor module. The use of the heat dissipation structure overcomes the defects of a traditional flat-plate cooling plate, effectively improves the convective heat transfer coefficient and heat dissipation area of an interface between fluid and solid, and increases heat transferred by macroscopic flow of fluid and heat transferred by the heat conduction of molecules in the fluid. Therefore, the heat dissipation performance of the power semiconductor module is enhanced and the thermal reliability and service life of the power semiconductor module are improved. The invention is set out in the appended set of claims.

In order to solve the above technical problems, the heat dissipation structure of the cooling plate for the power semiconductor module according to the present disclosure includes a power chip, a first solder layer, a copper-clad ceramic substrate, a second solder layer and a cooling plate body arranged sequentially from top to bottom. The heat dissipation structure further includes a straight rib mechanism arranged on a bottom surface of the cooling plate body and a pin rib mechanism arranged on a surface of the straight rib mechanism. The straight rib mechanism includes multiple straight ribs arranged on the bottom surface of the cooling plate body, and each of the multiple straight ribs has a cross-section that is triangular. The pin rib mechanism includes multiple pin ribs arranged on side surfaces of the multiple straight ribs.

Further, the arrangement of the multiple straight ribs on the bottom surface of the cooling plate body is of no gaps or is spaced.

Further, the multiple straight ribs on the bottom surface of the cooling plate body is arranged at an angle of 0 to 90 degrees relative to a flow direction of coolant.

Further, each of the multiple pin ribs is circular, elliptical or polygonal in cross-section.

Further, the multiple pin ribs are arranged in a straight line along the flow direction of the coolant. Alternatively, the multiple pin ribs are staggered along the flow direction of the coolant.

Further, the multiple pin ribs are arranged in at least one row between adjacent rib bases or adjacent rib tops of the multiple straight ribs.

Because the heat dissipation structure of the cooling plate of the power semiconductor module according to the present disclosure adopts the above technical solutions, that is, the heat dissipation structure includes a power chip, a first solder layer, a copper-clad ceramic substrate, a second solder layer and a cooling plate body arranged sequentially from top to bottom. The heat dissipation structure further includes a straight rib mechanism arranged on a bottom surface of the cooling plate body, and a pin rib mechanism arranged on a surface of the straight rib mechanism. The use of the heat dissipation structure overcomes the defects of a traditional flat cooling plate, effectively improves the convective heat transfer coefficient and heat dissipation area of an interface between fluid and solid, and increases heat transferred by macroscopic flow of fluid and heat transferred by the heat conduction of molecules in the fluid. Therefore, the heat dissipation performance of the power semiconductor module is enhanced and the thermal reliability and service life of the power semiconductor module are improved.

## BRIEF DESCRIPTION OF THE DRAWINGS

The present disclosure is further described in detail in conjunction with the accompanying drawings and embodiments below. In the drawings:

Figure 1 is a schematic diagram illustrating heat dissipation mechanism of a flat cooling plate;

Figure 2 is a schematic diagram illustrating heat dissipation mechanism of a flat cooling plate with pin ribs at the bottom;

Figure 3 is a schematic diagram illustrating a heat dissipation structure of a cooling plate for a power semiconductor module according to the present disclosure;

Figure 4 is a top view of the heat dissipation structure in Figure 3;

Figure 5 is a bottom view of the heat dissipation structure in Figure 3;

Figure 6 is an axonometric view of the heat dissipation structure;

Figure 7 is a schematic diagram illustrating a first arrangement of straight ribs and pin ribs in the heat dissipation structure;

Figure 8 is a schematic diagram illustrating a second arrangement of straight ribs and pin ribs in the heat dissipation structure;

Figure 9 is a schematic diagram illustrating a third arrangement of straight ribs and pin ribs in the heat dissipation structure;

Figure 10 is a schematic diagram illustrating a fourth arrangement of straight ribs and pin ribs in the heat dissipation structure;

Figure 11 is a schematic diagram illustrating a fifth arrangement of straight ribs and pin ribs in the heat dissipation structure;

Figure 12 is a schematic diagram illustrating a sixth arrangement of straight ribs and pin ribs in the heat dissipation structure;

Figure 13 is a schematic diagram illustrating the heat dissipation structure in which straight ribs are arranged at intervals along an extending direction and pin ribs are arranged on side surfaces of the straight ribs;

Figure 14 is a bottom view of the heat dissipation structure in Figure 13;

Figure 15 is a schematic diagram illustrating the heat dissipation structure in which straight ribs are arranged at intervals along an extending direction and pin ribs are arranged on rib bases and rib tops of the straight ribs;

Figure 16 is a bottom view of the heat dissipation structure in Figure15;

Figure 17 is a schematic diagram illustrating the heat dissipation structure in which straight ribs are arranged at an angle with a flow direction of coolant; and

Figure18 is a schematic diagram illustrating heat dissipation mechanism of the heat dissipation structure.

## DETAILED DESCRIPTION

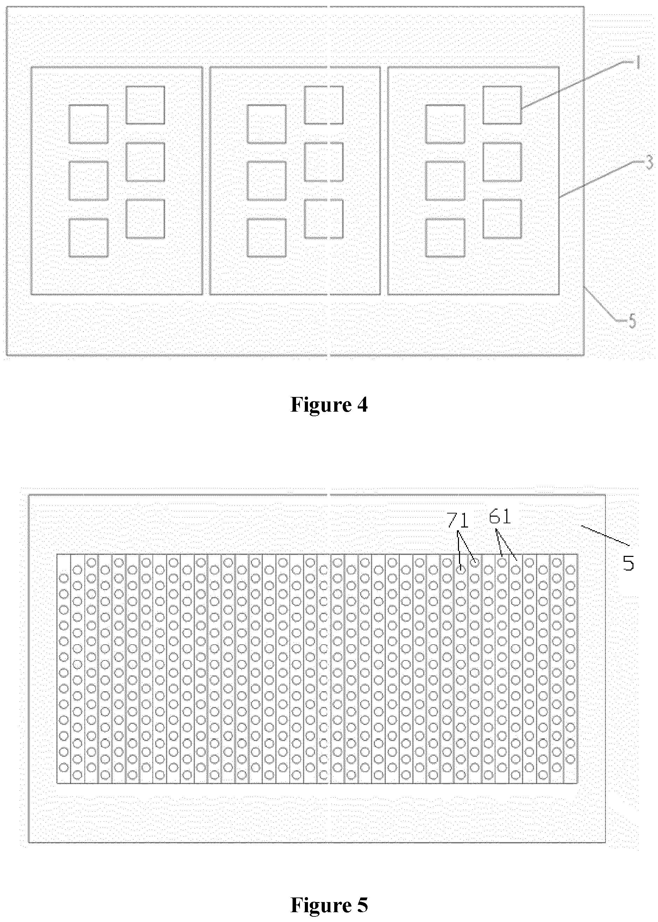

In the embodiments as shown in Figures 3, 4, 5 and 6, a heat dissipation structure of a cooling plate for a power semiconductor module according to the present disclosure includes a power chip 1, a first solder layer 2, a copper-clad ceramic substrate 3, a second solder layer 4 and a cooling plate body 5 arranged sequentially from top to bottom. The heat dissipation structure further includes a straight rib mechanism 6 arranged on a bottom surface of the cooling plate body 5, and a pin rib mechanism 7 arranged on a surface of the straight rib mechanism 6.

According to the present invention the straight rib mechanism 6 includes multiple straight ribs 61 arranged on the bottom surface of the cooling plate body 5, and each of the multiple straight ribs 61 has a cross-section that is triangular, or preferably convex arc-shaped or concave arc-shaped.

Preferably, the arrangement of the multiple straight ribs 61 on the bottom surface of the cooling plate body 5 is of no gaps or is spaced.

Preferably, the multiple straight ribs 61 on the bottom surface of the cooling plate body 5 is arranged at an angle of 0 to 90 degrees relative to a flow direction of coolant.

Preferably, the pin rib mechanism 7 includes multiple pin ribs 71 arranged on rib bases, rib tops and side surfaces of the multiple straight ribs 61, and each of the multiple pin ribs 71 is circular, elliptical or polygonal in cross-section.

Preferably, the multiple pin ribs 71 are distributed in a straight line or are staggered along the flow direction of the coolant.

Preferably, the multiple pin ribs 71 are arranged in at least one row between adjacent rib bases or adjacent rib tops of the multiple straight ribs 61.

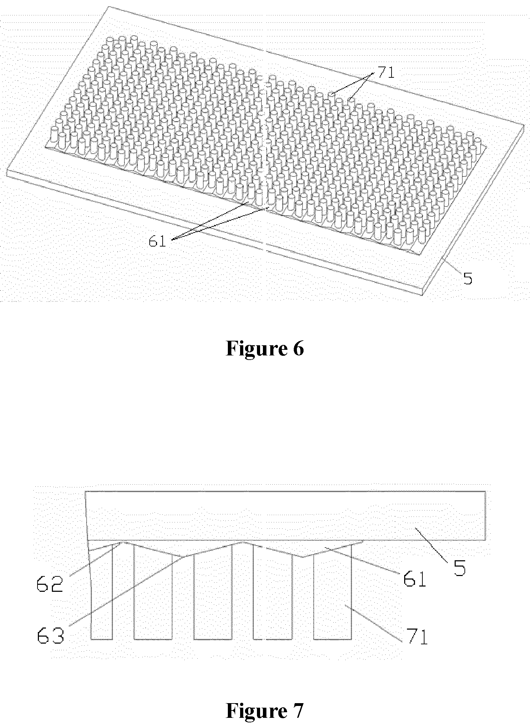

As shown in Figure 7, the straight ribs 61 of the cooling structure are triangular in cross-section and are arranged without gaps on the bottom surface of the cooling plate body 5 along the extending direction. The pin rib 71 is arranged on a side surfaces of the straight rib 61, i.e., between a rib base 62 and a rib top 63 of the straight rib 61.

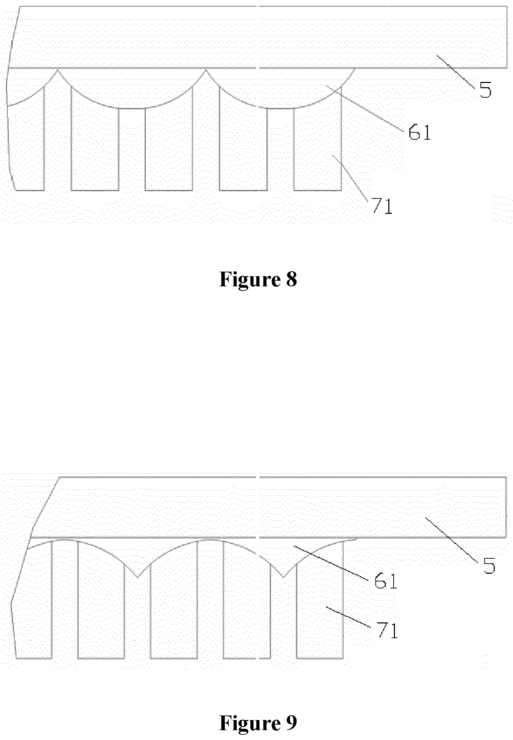

As shown in Figure 8, the straight ribs 61 of the cooling structure are convex arc-shaped in cross-section and are arranged without gaps on the bottom surface of the cooling plate body 5 along the extending direction. The pin rib 71 is arranged on a side of a convex surface.

As shown in Figure 9, the straight ribs 61 of the cooling structure are concave arc-shaped in cross-section and are arranged without gaps on the bottom surface of the cooling plate body 5 along the extending direction. The pin rib 71 is arranged on an inner side of a convex surface.

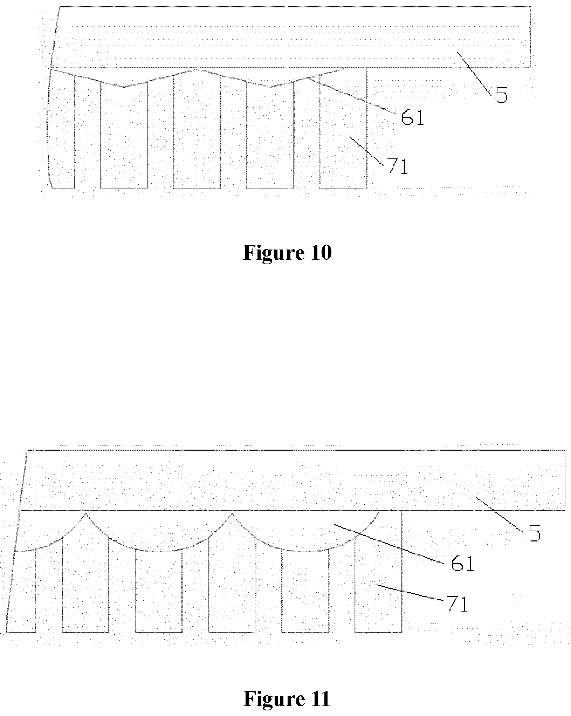

As shown in Figure 10, the straight ribs 61 of the cooling structure are triangular in cross-section and are arranged without gaps on the bottom surface of the cooling plate body 5 along the extending direction. A pin rib 71 is arranged on a rib base of the straight rib 61, and another pin rib 71 is arranged on a rib top of the straight rib 61.

As shown in Figure 11, the straight ribs 61 of the cooling structure are convex arc-shaped in cross-section and are arranged without gaps on the bottom surface of the cooling plate body 5 along the extending direction. A pin rib 71 is arranged on a top of a convex surface, and another pin rib 71 is arranged at a side of the convex surface.

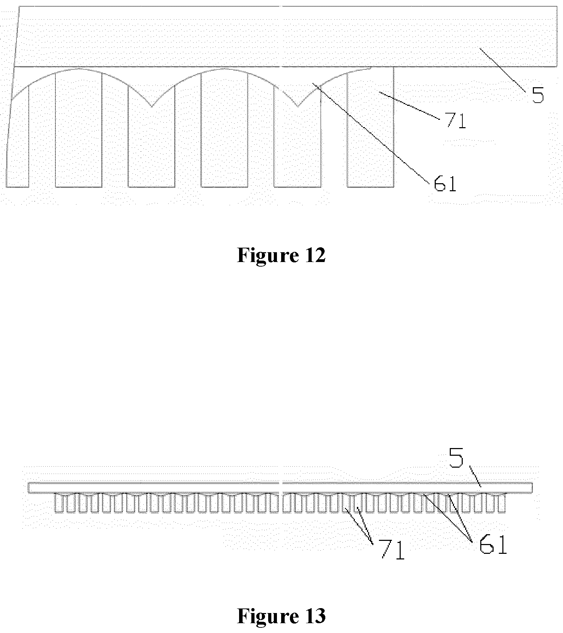

As shown in Figure 12, the straight ribs 61 of the cooling structure are concave arc-shaped in cross-section and are arranged without gaps on the bottom surface of the cooling plate body 5 along the extending direction. A pin rib 71 is arranged on a bottom of a concave surface, and another pin rib 71 is arranged at a side of the concave surface.

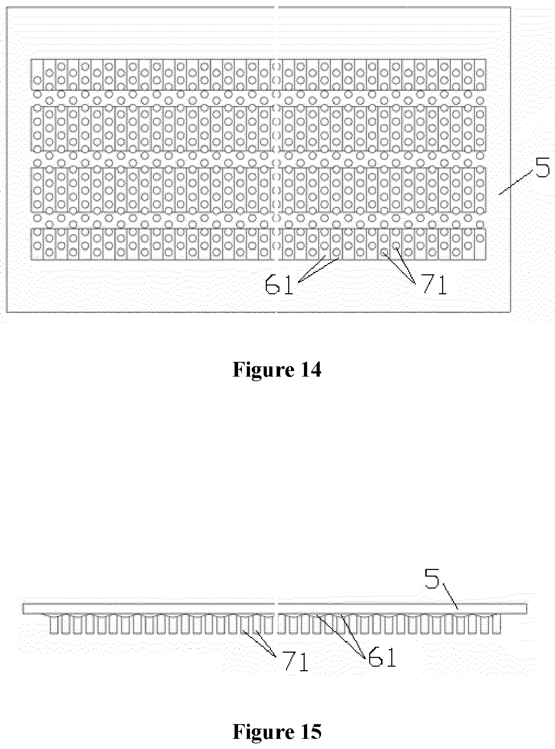

As shown in Figures 13 and 14, the straight ribs 61 of the cooling structure are triangular in cross-section and are arranged at intervals on the bottom surface of the cooling plate body 5 along the extending direction. The pin rib 71 is arranged on a side surface of the straight rib 61.

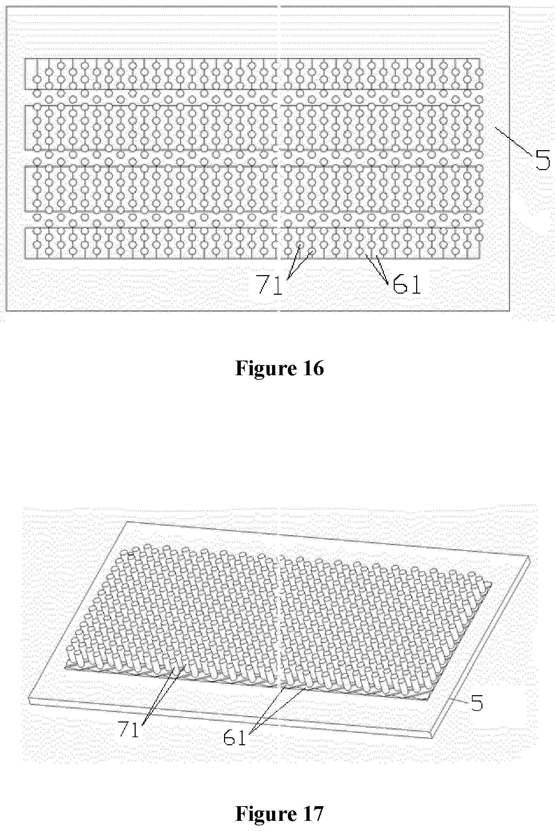

As shown in Figures 15 and 16, the straight ribs 61 of the cooling structure are triangular in cross-section and are arranged at intervals on the bottom surface of the cooling plate body 5 along the extending direction. A pin rib 71 is arranged on a rib base of the straight rib 61, and another pin rib 71 is arranged on a rib top of the straight rib 61.

As shown in Figure 17, the straight ribs 61 of the cooling structure are triangular in cross-section and are arranged without gaps on the bottom surface of the cooling plate body 5 along the extending direction. A pin rib 71 is arranged on a rib base of the straight rib 61, and another pin rib 71 is arranged on a rib top of the straight rib 61. Each of the straight rib 61 is arranged at an angle with a flow direction of the coolant in the direction along which the bottom surface of the cooling plate body 5 extends.

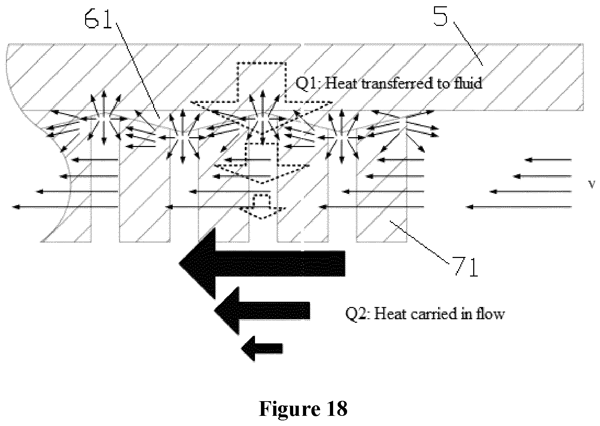

As shown in Figure 18, with the heat dissipation structure, the convective heat transfer coefficient $h$ and the heat transfer area $A$ are increased with regard to the defects of the conventional technology, so that the heat dissipation capability of the cooling plate 5 is significantly enhanced.

According to Equation (1), the amount of heat carried away by convective heat transfer between the cooling plate 5 and the coolant is:

$$\Phi' = h'\eta A' \Delta T \qquad (2)$$

In Equation (2), $n$ is the total efficiency of rib surfaces of the heat dissipation structure of the cooling plate, $\Phi'$, $h'$, and $A'$ are the amount of heat carried away by the convective heat transfer, the convective heat transfer coefficient and the total heat dissipation area corresponding to the cooling plate provided with ribs, respectively.

According to the convective heat transfer theory, due to the straight ribs 61 and the pin ribs 71, the fluid switches from the laminar flow to the turbulent flow at the interface between fluid and solid, and the convective heat transfer coefficient $h'$ in the turbulent flow is significantly larger than that in the laminar flow, thereby increasing the amount of heat $Q_2$ transferred by the macroscopic flow of the fluid, which outperforms the conventional technology. In addition, the heat dissipation area of the interface between fluid and solid of the heat dissipation structure is significantly increased, thereby increasing the amount of heat $Q_1$ transferred by the heat conduction of the molecules in the fluid. Therefore, the amount of heat $\Phi'$ carried away through the convective heat exchange of the heat dissipation structure is significantly larger than that in the conventional technology, thereby effectively enhancing the heat dissipation capability of the cooling plate.

As shown in Figure 18, due to the combination of the straight ribs and pin ribs in the cooling structure, the fluid micelles at the interface between fluid and solid not only moves in the main direction, but also pulsate irregularly. When the fluid micelles pulsate from one position to another, vigorous mixing occurs between the fluid micelles, and additional heat exchange occurs between the fluid in the layers at different temperatures. That is, the coolant at the interface between fluid and solid switches from the laminar flow to the turbulent flow. The convective heat transfer coefficient $h'$ in the turbulent flow is significantly larger than that in the laminar flow, which increases the amount of heat $Q_2$ transferred by the macroscopic flow of the fluid. In addition, with the heat dissipation structure, the heat dissipation area of the interface between fluid and solid is significantly increased, thereby increasing the amount of heat $Q_1$ trans-

ferred by the heat conduction of the molecules in the fluid. The use of the heat dissipation structure significantly enhances the heat dissipation performance of the power semiconductor module, improves the thermal reliability of the power semiconductor module, significantly reduces the comprehensive cost for heat dissipation of the power semiconductor module, and improves the service life of the power semiconductor module.

**Claims**

1. A heat dissipation structure of a cooling plate for a power semiconductor module, comprising: a power chip (1), a first solder layer (2), a copper-clad ceramic substrate (3), a second solder layer (4) and a cooling plate body (5) which are arranged in a sequence from top to bottom, wherein

    the heat dissipation structure further comprises a straight rib mechanism (6) and a pin rib mechanism (7), the straight rib mechanism (6) is arranged on a bottom surface of the cooling plate body (5), and the pin rib mechanism (7) is arranged on a surface of the straight rib mechanism (6),
    the straight rib mechanism (6) comprises a plurality of straight ribs (61) arranged on the bottom surface of the cooling plate body (5), and each of the plurality of straight ribs (61) has a cross-section that is triangular,
    the pin rib mechanism (7) comprises a plurality of pin ribs (71) arranged on side surfaces of the plurality of straight ribs (61).

2. The heat dissipation structure of a cooling plate for a power semiconductor module according to claim 1, wherein the arrangement of the plurality of straight ribs (61) on the bottom surface of the cooling plate body (5) is of no gaps or is spaced.

3. The heat dissipation structure of a cooling plate for a power semiconductor module according to claim 1 or 2, wherein the plurality of straight ribs (61) on the bottom surface of the cooling plate body (5) is arranged at an angle of 0 to 90 degrees relative to a flow direction of coolant.

4. The heat dissipation structure of a cooling plate for a power semiconductor module according to claim 3, wherein each of the plurality of pin ribs (71) has a cross-section that is circular, elliptical or polygonal.

5. The heat dissipation structure of a cooling plate of a power semiconductor module according to claim 4, wherein the plurality of pin ribs (71) is arranged in a straight line along the flow direction of the coolant; or the plurality of pin ribs (71) are staggered along the flow direction of the coolant.

6. The heat dissipation structure of a cooling plate for a power semiconductor module according to claim 3 or 4, wherein the plurality of pin ribs (71) is arranged in at least one row between adjacent rib bases (62) or adjacent rib tops (63) of the plurality of straight ribs (61).

## Patentansprüche

1. Wärmeableitungsstruktur einer Kühlplatte für ein Leistungshalbleitermodul, mit: einem Leistungschip (1), einer ersten Lotschicht (2), einem kupferbeschichteten Keramiksubstrat (3), einer zweiten Lotschicht (4) und einem Kühlplattenkörper (5), die in einer Abfolge von oben nach unten angeordnet sind, wobei

die Wärmeableitungsstruktur ferner einen Geradrippenmechanismus (6) und einen Stiftrippenmechanismus (7) umfasst, der Geradrippenmechanismus (6) an einer Unterseite des Kühlplattenkörpers (5) angeordnet ist und der Stiftrippenmechanismus (7) an einer Oberfläche des Geradrippenmechanismus (6) angeordnet ist,

der Geradrippenmechanismus (6) mehrere an der Unterseite des Kühlplattenkörpers (5) angeordnete Geradrippen (61) umfasst und jede der mehreren Geradrippen (61) einen Querschnitt aufweist, der dreieckig ist,

der Stiftrippenmechanismus (7) mehrere an Seitenflächen der mehreren Geradrippen (61) angeordnete Stiftrippen (71) umfasst.

2. Wärmeableitungsstruktur einer Kühlplatte für ein Leistungshalbleitermodul nach Anspruch 1, wobei die mehreren Geradrippen (61) an der Unterseite des Kühlplattenkörpers (5) ohne Zwischenräume oder beabstandet angeordnet sind.

3. Wärmeableitungsstruktur einer Kühlplatte für ein Leistungshalbleitermodul nach Anspruch 1 oder 2, wobei die mehreren Geradrippen (61) an der Unterseite des Kühlplattenkörpers (5) in einem Winkel von 0 bis 90° relativ zu einer Kühlmittelströmungsrichtung angeordnet sind.

4. Wärmeableitungsstruktur einer Kühlplatte für ein Leistungshalbleitermodul nach Anspruch 3, wobei jede der mehreren Stiftrippen (71) einen Querschnitt aufweist, der kreisförmig, elliptisch oder polygonal ist.

5. Wärmeableitungsstruktur einer Kühlplatte eines Leistungshalbleitermoduls nach Anspruch 4, wobei die mehreren Stiftrippen (71) in einer Geraden entlang der Strömungsrichtung des Kühlmittels angeordnet sind oder die mehreren Stiftrippen (71) entlang der Strömungsrichtung des Kühlmittels versetzt angeordnet sind.

6. Wärmeableitungsstruktur einer Kühlplatte für ein Leistungshalbleitermodul nach Anspruch 3 oder 4, wobei die mehreren Stiftrippen (71) in mindestens einer Reihe zwischen benachbarten Rippenbasen (62) oder benachbarten Rippenspitzen (63) der mehreren Geradrippen (61) angeordnet sind.

## Revendications

1. Structure de dissipation de chaleur d'une plaque de refroidissement pour un module semi-conducteur de puissance, comprenant : une puce de puissance (1), une première couche de brasage (2), un substrat céramique recouvert de cuivre (3), une deuxième couche de brasage (4) et un corps de plaque de refroidissement (5) agencés successivement de haut en bas,

la structure de dissipation de chaleur comprenant en outre un mécanisme à nervures droites (6) et un mécanisme à nervures en broches (7), le mécanisme à nervures droites (6) étant agencé sur une surface inférieure du corps de plaque de refroidissement (5), et le mécanisme à nervures en broches (7) étant agencé sur une surface du mécanisme à nervures droites (6), le mécanisme à nervures droites (6) comprenant une pluralité de nervures droites (61) agencées sur la surface inférieure du corps de plaque de refroidissement (5), et chacune de la pluralité de nervures droites (61) présentant une section transversale triangulaire, le mécanisme à nervures en broches (7) comprenant une pluralité de nervures en broches (71) agencées sur des surfaces latérales de la pluralité de nervures droites (61).

2. Structure de dissipation de chaleur d'une plaque de refroidissement pour un module semi-conducteur de puissance selon la revendication 1, les plusieurs nervures droites (61) étant agencées sans espace ou de manière espacée sur la surface inférieure du corps de plaque de refroidissement (5).

3. Structure de dissipation de chaleur d'une plaque de refroidissement pour un module semi-conducteur de puissance selon la revendication 1 ou 2, les plusieurs nervures droites (61) sur la surface inférieure du corps de plaque de refroidissement (5) étant agencées à un angle de 0 à 90 degrés par rapport à un sens d'écoulement d'agent réfrigérant.

4. Structure de dissipation de chaleur d'une plaque de refroidissement pour un module semi-conducteur de puissance selon la revendication 3, chacune de la pluralité de nervures en broches (71) présentant une section transversale qui est circulaire, elliptique ou polygonale.

5. Structure de dissipation de chaleur d'une plaque de refroidissement d'un module semi-conducteur de puissance selon la revendication 4, les plusieurs nervures en broches (71) étant agencées en ligne droite le long du sens d'écoulement de l'agent réfrigérant, ou les plusieurs nervures en broches (71) étant agencées en quinconce le long du sens d'écoulement de l'agent réfrigérant.

6. Structure de dissipation de chaleur d'une plaque de refroidissement pour un module semi-conducteur de puissance selon la revendication 3 ou 4, les plusieurs nervures en broches (71) étant agencées en au moins une rangée entre des bases de nervure adjacentes (62) ou des sommets de nervure adjacents (63) de la pluralité de nervures droites (61).

Q1: Heat transferred to fluid

v

Q2: Heat carried in flow

**Figure 1**

**Figure 2**

**Figure 3**

**Figure 4**

**Figure 5**

EP 4 203 014 B1

Figure 6

Figure 7

**Figure 8**

**Figure 9**

5

61

71

**Figure 10**

5

61

71

**Figure 11**

**Figure 12**

**Figure 13**

**Figure 14**

**Figure 15**

**Figure 16**

**Figure 17**

**Figure 18**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202011230363
- EP 3460838 A1
- US 10015907 B2
- JP 2016004828 A
- US 20090145581 A1